# EUROPÄISCHE PATENTSCHRIFT

(11) **EP 2 378 579 B1**
(45) Veröffentlichungstag und Bekanntmachung des Hinweises auf die Patenterteilung: **27.07.2016**
(21) Anmeldenummer: 11156613.9
(22) Anmeldetag: 02.03.2011
(51) Int. Cl.: H01L 41/083, H01L 41/047

(54) **Piezoelektrischer Aktor**
Piezoelectric actuator
Actionneur piézo-électrique

(30) Priorität: 16.04.2010 DE 102010027845
(43) Veröffentlichungstag der Anmeldung: 19.10.2011
(73) Patentinhaber: Robert Bosch GmbH, 70469 Stuttgart (DE)
(72) Erfinder: Benes, Jan, 96047, Bamberg (DE)

(56) Entgegenhaltungen:
- EP-A2- 1 233 461
- EP-A2- 2 149 922
- WO-A1-2007/012485
- WO-A1-2007/012654
- JP-A- S63 288 075

## Beschreibung

### Stand der Technik

Die Erfindung betrifft einen piezoelektrischen Aktor mit einer Vielzahl von keramischen Schichten und einer Vielzahl von zwischen den keramischen Schichten angeordneten Elektrodenschichten.

Aus der DE 100 62 672 A1 ist ein piezoelektrisches Bauelement in monolithischer Vielschichtbauweise mit einem Stapel aus Keramikschichten und jeweils einer zwischen zwei Keramikschichten angeordneten Elektrodenschicht bekannt. Das bekannte piezoelektrische Bauelement kann hierbei aus keramischen Grünfolien hergestellt sein, welche einen thermohydrolitisch abbaubaren Binder enthalten, der beispielsweise eine Polyurethandispersion ist. Die Keramikschichten können hierbei Körner mit einer Korngröße zwischen 0,8 µm und 5 µm enthalten. Die Keramikschichten können aus Bleizirkonattitanat hergestellt sein. Zwischen denn Keramikschichten können sich mittels Siebdruck aufgebrachte Edelmetall-Innenelektroden aus Silber und Palladium mit einem Molverhältnis von 70 zu 30 befinden. Bei dem bekannten Bauelement sind diese Elektrodenschichten allerdings als kupferhaltige Innenelektroden ausgestaltet.

Das aus der DE 100 62 672 A1 bekannte piezoelektrische Bauelement hat den Nachteil, dass es beim Anlegen einer elektrischen Spannung zwischen die Elektrodenschichten infolge der Dehnung der keramischen Schichten im Übergang zu einem passiven Bereich zu mechanischen Spannungen kommt, die zu Rissen führen können.

Bei der Ausgestaltung eines piezoelektrischen Bauelements ist es denkbar, dass zum Vermeiden solcher großen mechanischen Spannungen ein Übergangsbereich vorgesehen ist, in dem Übergangsschichten mit einer größeren Schichtdicke vorgesehen sind, wie beispielsweise aus der EP 1 233 461 A2 bekannt. Durch die größere Schichtdicke kommt es zu einer Reduzierung des elektrischen Feldes und somit auch zu einer geringeren Dehnung. Das elektrische Feld ergibt sich nämlich zumindest näherungsweise als Bruchteilswert mit einem Zähler, der gleich der angelegten Spannung zwischen die angrenzenden Elektrodenschichten ist, und einem Nenner, der gleich dem Abstand zwischen den Elektrodenschichten ist.

Allerdings hat solch eine denkbare Ausgestaltung den Nachteil, dass der aktive Bereich bei einer vorgegebenen Gesamtlänge des piezoelektrischen Aktors infolge der Übergangsschichten verkürzt ist. Da die Übergangsschichten auch noch eine vergrößerte Dicke aufweisen, kommt es zu einer überproportionalen Verkürzung des verbleibenden aktiven Bereichs mit der vorgegebenen nominalen Schichtdicke der keramischen Schichten.

Die EP 1 233 461 A2 lehrt als Alternative, dass der Übergangsbereich aus einem piezokeramischen Werkstoff besteht, dessen Schwindung und Dehnungsverhalten zwischen den Eigenschaften des aktiven und den Eigenschaften des passiven Bereichs liegt.

### Vorteile der Erfindung

Der piezoelektrische Aktor mit den Merkmalen des Anspruchs 1 hat demgegenüber den Vorteil, dass eine verbesserte Ausgestaltung ermöglicht ist. Speziell ergibt sich ein vorteilhaftes Arbeitsvermögen, wobei die Robustheit und Belastbarkeit verbessert ist.

In vorteilhafter Weise ist der piezoelektrische Koeffizient ein d₃₃-Koeffizient. Das keramische Material der keramischen Schichten im Übergangsbereich hat dann einen d₃₃-Koeffizienten, der kleiner ist als der d₃₃-Koeffizient des keramischen Materials der keramischen Schichten im aktiven Bereich. Hierbei kann die Schichtdicke der keramischen Schichten im aktiven Bereich und im Übergangsbereich gleich groß vorgegeben sein. Auf Grund des reduzierten piezoelektrischen Koeffizienten kommt es im Übergangsbereich zu einer reduzierten Dehnung, so dass ein vorteilhafter Dehnungsübergang gewährleistet ist. Hierdurch verbessert sich die Robustheit und Belastbarkeit des piezoelektrischen Aktors. Da der Übergangsbereich mit vergleichsweise dünnen keramischen Schichten ausgestaltet ist, verbleibt ein relativ großer Teil für die keramischen Schichten des aktiven Bereichs. Speziell kann eine relativ große Anzahl an aktiven keramischen Schichten im aktiven Bereich bei vorgegebener Schichtdicke realisiert werden.

Vorteilhaft ist es, dass der piezoelektrische Koeffizient des keramischen Materials der keramischen Schichten im Übergangsbereich zumindest näherungsweise konstant ist und/oder dass der piezoelektrische Koeffizient des keramischen Materials der keramischen Schicht im aktiven Bereich zumindest näherungsweise konstant ist. Hierdurch ergibt sich zum einen innerhalb des aktiven Bereichs und zum anderen innerhalb des Übergangsbereichs ein homogenes Dehnungsverhalten, so dass mechanische Spannungen in diesen Bereichen vermieden sind. Zum anderen vereinfacht sich die Herstellung des piezoelektrischen Aktors.

Vorteilhaft ist es, dass das keramische Material der keramischen Schichten im Übergangsbereich und das keramische Material der keramischen Schichten im aktiven Bereich eine unterschiedliche Zusammensetzung aufweisen. Hierbei kann die unterschiedliche Zusammensetzung beispielsweise durch einen unterschiedlichen Versatz, eine Zudotierung oder eine unterschiedliche Zudotierung realisiert werden. Möglich ist es auch, dass eine In-situ-Dotierung beim Sinterprozess erfolgt und/oder dass eine unterschiedliche In-situ-Dotierung beim Sinterprozess vorgegeben ist. Beispielsweise können Dotierungsschichten aufgebracht werden. Vorteilhaft ist es auch, dass eine geänderte Zusammensetzung der als Innenelektroden ausgestalteten Elektrodenschichten zum Einsatz kommt. Beispielsweise kann der Anteil von Silber an den Elektrodenschichten für die Elektrodenschichten im aktiven Bereich und die Elektrodenschichten im Übergangsbereich unterschiedlich vorgegeben sein. Möglich ist es auch, dass zusätzlich oder alternativ Dotierungszusätze eingesetzt werden, um eine geänderte Zusammensetzung der Elektrodenschichten zu erzielen. Somit kann der piezoelektrische Koeffizient direkt beeinflusst werden oder durch unterschiedliche Korngrößen in dem keramischen Material des aktiven Bereichs und dem keramischen Material des Übergangsbereichs indirekt beeinflusst werden. Zudem kann eine reduzierte Korngröße und eine damit verbundene Reduzierung des piezoelektrischen Koeffizienten durch eine veränderte Partikelgrößenverteilung des Vormaterials erzielt werden.

Vorteilhaft ist es auch, dass ein passiver Bereich vorgesehen ist und dass die keramischen Schichten des Übergangsbereichs zwischen dem aktiven Bereich und dem passiven Bereich angeordnet sind. Hierdurch kann ein vorteilhafter Übergang geschaffen werden. Beispielsweise kann ein vorteilhafter Übergang zu einem metallischen Aktorkopf oder einem metallischen Aktorfuß geschaffen werden.

Vorteilhaft ist es auch, dass zumindest ein weiterer Übergangsbereich vorgesehen ist, dass der Übergangsbereich zwischen dem aktiven Bereich und dem weiteren Übergangsbereich angeordnet ist und dass der piezoelektrische Koeffizient eines keramischen Materials der keramischen Schichten im weiteren Übergangsbereich kleiner ist als der piezoelektrische Koeffizient des keramischen Materials der keramischen Schichten im Übergangsbereich. Hierdurch kann von dem aktiven Bereich zu dem passiven Bereich eine stufenweise Reduzierung des piezoelektrischen Koeffizienten und somit des Dehnungsvermögens erzielt werden. Hierdurch kann ein vorteilhafter Übergang realisiert werden. Möglich ist es auch, dass mehr als zwei Übergangsbereiche vorgesehen sind, in denen sich der piezoelektrische Koeffizient vom aktiven Bereich zum passiven Bereich hin nach und nach verringert. Hierfür kann beispielsweise der Silberanteil der als Innenelektroden ausgestalteten Elektrodenschichten in den nebeneinander angeordneten Übergangsbereichen vom aktiven Bereich zum passiven Bereich hin nach und nach reduziert werden. Dies beeinflusst bei der Herstellung, insbesondere während des Sinterprozesses, das piezokeramische Material der angrenzenden keramischen Schichten.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 einen piezoelektrischen Aktor in einer auszugsweisen, schematischen Schnittdarstellung entsprechend einem ersten Ausführungsbeispiel der Erfindung und
Fig. 2 den in Fig. 1 dargestellten piezoelektrischen Aktor entsprechend einem zweiten Ausführungsbeispiel der Erfindung.

### Ausführungsformen der Erfindung

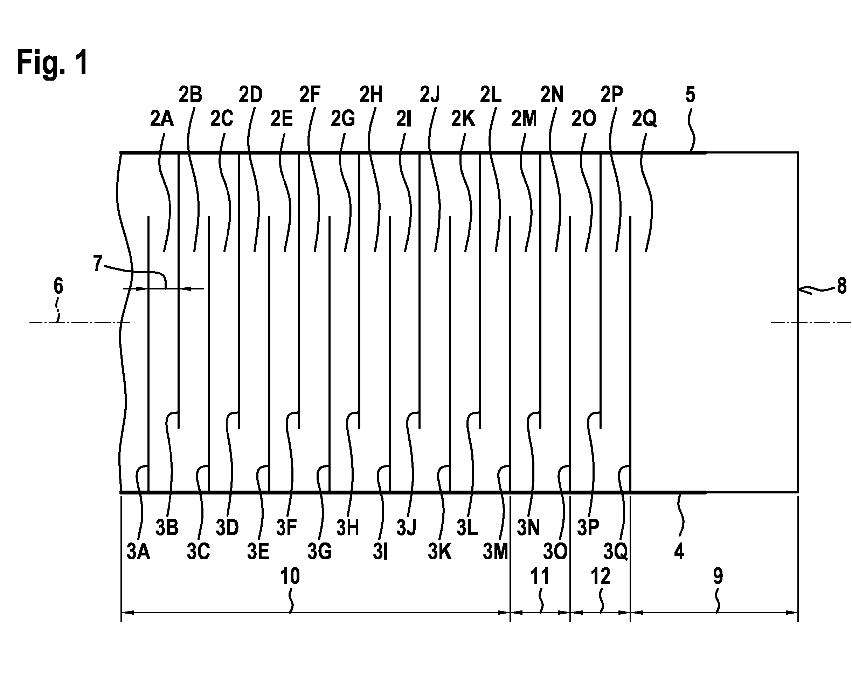

Fig. 1 zeigt einen piezoelektrischen Aktor 1 in einer auszugsweisen, schematischen Schnittdarstellung entsprechend einem ersten Ausführungsbeispiel. Der piezoelektrische Aktor 1 weist eine Vielzahl von keramischen Schichten 2A bis 2Q und eine Vielzahl von zwischen den keramischen Schichten 2A bis 2Q angeordneten Elektrodenschichten 3A bis 3Q auf. Hierbei sind die keramischen Schichten 2A bis 2Q aus einem piezoelektrischen Material gebildet. Die Elektrodenschichten 3A bis 3Q sind als Innenelektrodenschichten 3A bis 3Q ausgestaltet und abwechselnd mit Außenelektroden 4, 5 verbunden. Zwischen die Außenelektroden 4, 5 ist eine elektrische Spannung anlegbar, um in den keramischen Schichten 2A bis 2Q elektrische Felder zu erzeugen, die entsprechend dem piezoelektrischen Effekt eine Dehnung der keramischen Schichten 2A bis 2Q entlang einer Längsachse 6 zur Folge haben. Die Stärke des elektrischen Feldes ergibt sich hierbei näherungsweise aus dem Quotienten der angelegten elektrischen Spannung und einem Abstand 7 der angrenzenden Elektrodenschichten. Der Abstand 7 ist hierbei gleich der Dicke der einzelnen keramischen Schichten 2A bis 2Q. In diesem Ausführungsbeispiel weisen alle keramischen Schichten 2A bis 2P den gleichen Abstand 7 auf. Die keramische Schicht 2Q ist die letzte Schicht, die an eine Stirnseite 8 des piezoelektrischen Aktors 1 angrenzt. Da die keramische Schicht 2Q nur an eine der Elektrodenschichten, nämlich die Elektrodenschicht 3Q angrenzt, ist diese passiv. Durch die keramische Schicht 2Q ist daher ein passiver Bereich 9 des piezoelektrischen Aktors 1 vorgegeben. Beispielsweise kann der piezoelektrische Aktor 1 so montiert werden, dass an der Stirnseite 8 ein Übergangsstück, insbesondere ein Aktorkopf oder ein Aktorfuß, anliegt. Hierdurch ist durch den passiven Bereich 9 ein dehnungsfreier Bereich 9 am Aktorkopf beziehungsweise Aktorfuß gebildet. Beim Laden und Entladen des piezoelektrischen Aktors kommt es speziell in den an den passiven Bereich 9 angrenzenden keramischen Schichten 20, 2P zu mechanischen Spannungen. Um eine Rissbildung oder dergleichen zu verhindern, ist es von Vorteil, dass das Ausmaß dieser mechanischen Spannungen begrenzt ist.

Bekannt ist es, dass die Schichtdicke der an den passiven Bereich 9 angrenzenden keramischen Schichten vergrößert wird. Hierdurch reduziert sich beim Anlegen einer elektrischen Spannung das in den keramischen Schichten mit vergrößerter Schichtdicke entstehende elektrische Feld, da alle Kondensatorschichten über die Außenelektroden 4, 5 parallel an eine Spannungsquelle angeschlossen sind. Somit kann selektiv eine geringere Dehnung in einzelnen keramischen Schichten erzielt werden. Diese stufenweise Verringerung der Dehnung der Piezokeramik in den einzelnen Schichten führt zu einem stufenartigen Übergang der elektromechanischen Materialbelastung von einem aktiven Bereich 10 zu dem passiven Bereich 9.

Somit ist durch eine stufenweise Schichtdickenerhöhung die Robustheit und Belastbarkeit verbesserbar. Bei einer unveränderten Schichtdicke 7 der keramischen Schichten 2A bis 2L im aktiven Bereich 10 hat die Ausgestaltung eines solchen Schichtdickenübergangs jedoch einen Verlust an Arbeitsvermögen zur Folge. Speziell in Bezug auf eine vorgegebene Auslegung des piezoelektrischen Aktors 1, insbesondere Länge des piezoelektrischen Aktors 1, kann dies zu Problemen in Bezug auf eine vorgegebene Spezifikation hinsichtlich eines Arbeitsvermögens führen. Gegebenenfalls ist eine solche Spezifikation dann nicht mehr einzuhalten. Dies ist zum einen durch die geringere prozentuale Dehnung der Schichten mit reduziertem elektrischen Feld bedingt. Zum anderen verstärkt sich dieser nachteilige Effekt auch auf das gesamte Arbeitsvermögen, da sich auf Grund der erhöhten Schichtdicke der sich geringer dehnenden Schichten die Anzahl der Schichten im aktiven Bereich 10 überproportional verringert. Somit verringert sich sowohl das Dehnungsvermögen einzelner Schichten als auch die Gesamtzahl der betätigbaren keramischen Schichten des piezoelektrischen Aktors 1. Somit werden zwei Effekte kombiniert, die sich jeweils ungünstig auf das Arbeitsvermögen des piezoelektrischen Aktors 1 auswirken.

Bei dem piezoelektrischen Aktor 1 des ersten Ausführungsbeispiels der Erfindung ist der Abstand 7 zwischen den Elektrodenschichten 3A bis 3Q zumindest näherungsweise konstant. Hierdurch ist auch die Schichtdicke 7 der betätigbaren keramischen Schichten 2A bis 2P konstant. Somit kommt es zu keiner Verringerung der Anzahl der betätigbaren keramischen Schichten 2A bis 2P des piezoelektrischen Aktors 1.

Außerdem weist der piezoelektrische Aktor 1 einen Übergangsbereich 11 und einen weiteren Übergangsbereich 12 auf. In dem Übergangsbereich 11 ist ein Dehnungsvermögen der keramischen Schichten 2M, 2N gegenüber den keramischen Schichten 2A bis 2L reduziert. Außerdem ist auch in dem weiteren Übergangsbereich 12 ein Dehnungsvermögen der keramischen Schichten 20, 2P gegenüber den keramischen Schichten 2M, 2N reduziert. Die keramischen Schichten 2A bis 2L des aktiven Bereichs 10 sind aus einem keramischen Material mit einem vorgegebenen piezoelektrischen Koeffizienten, nämlich einem d₃₃-Koeffizienten, ausgebildet. Für die keramischen Schichten 2M, 2N im Übergangsbereich 11 ist im Unterschied hierzu ein keramisches Material mit einem piezoelektrischen Koeffizienten, nämlich einem d₃₃-Koeffizienten, gewählt, der kleiner ist als der piezoelektrische Koeffizient des keramischen Materials im aktiven Bereich 10. Im weiteren Übergangsbereich 12 ist das keramische Material für die keramischen Schichten 20, 2P mit einem piezoelektrischen Koeffizienten, nämlich einem d₃₃-Koeffizienten, vorgegeben, der kleiner als der piezoelektrische Koeffizient des keramischen Materials im Übergangsbereich 11 und somit auch kleiner als der piezoelektrische Koeffizient des keramischen Materials im aktiven Bereich 10 ist. Somit nimmt das Dehnungsvermögen vom aktiven Bereich 10 zum passiven Bereich 9 über die Übergangsbereiche 11, 12 stufenweise ab. Hierbei weisen sowohl die keramischen Schichten 2M, 2N des Übergangsbereichs 11 als auch die keramischen Schichten 20, 2P des weiteren Übergangsbereichs 12 die gleiche Schichtdicke 7 auf wie die keramischen Schichten 2A bis 2L im aktiven Bereich 10.

In diesem Ausführungsbeispiel sind zwei Übergangsbereiche 11, 12 zwischen dem aktiven Bereich 10 und dem passiven Bereich 9 vorgesehen. Je nach Anzahl der vorgesehenen Übergangsbereiche kann ein mehr oder weniger fein abgestufter Übergang, insbesondere ein gradueller Übergang, von dem aktiven Bereich 10 zu dem passiven Bereich 9 realisiert werden. Hierbei werden in den Übergangsbereich 11, 12 reduzierte Dehnungen in den als Übergangsschichten 2M, 2N, 20, 2P dienenden keramischen Schichten 2M, 2N, 20, 2P ermöglicht. Somit ist für die Realisierung des Dehnungsübergangs kein überproportionaler Verlust an Arbeitsvermögen erforderlich. Entsprechend kann bei einem vorgegebenen Dehnungsübergang eine Steigerung des Arbeitsvermögens durch eine geometrische Verkleinerung der Übergangsbereiche 11, 12 erzielt werden.

Speziell kann ein stufenartiger Dehnungsübergang für den piezoelektrischen Aktor 1 zwischen dem aktiven Bereich 10 und dem passiven Bereich 9, bei dem mit unveränderter Schichtdicke 7 eine Verringerung der Dehnung realisiert wird, indem der d₃₃-Koeffizient in diesen keramischen Schichten 2M bis 2P gezielt reduziert wird, geschaffen werden, wobei die Dehnung entlang der Längsachse 6 proportional zu dem jeweiligen d₃₃-Koeffizienten ist. Die Reduzierung des piezoelektrischen d₃₃-Koeffizienten, der ein materialspezifischer Koeffizient ist, bei unveränderter Schichtdicke 7 kann durch Veränderung der Materialzusammensetzung des Ausgangsmaterials zur Herstellung der keramischen Schichte 2A bis 2Q erfolgen, wobei die Materialzusammensetzung der keramischen Schichten 2M bis 2P in Bezug auf die Materialzusammensetzung für die keramischen Schichten 2A bis 2L des aktiven Bereichs 10 verändert wird. Beispielsweise kann ein veränderter Versatz oder eine Zusatzdotierung bei den keramischen Schichten 2M, 2N des Übergangsbereichs 11 und den keramischen Schichten 20, 2P des weiteren Übergangsbereichs 12 durchgeführt werden. Eine Veränderung ist auch in situ im Sinterprozess möglich. Hierbei kann eine Dotierung erfolgen, die beispielsweise über die als Innenelektroden 3M bis 3Q dienenden Elektrodenschichten 3M bis 3Q erfolgt. Eine andere Möglichkeit besteht in der Veränderung der Partikelgrößenverteilung des Ausgangsmaterials. Hierbei kann durch eine reduzierte Korngröße für die keramischen Schichten 2M, 2N des Übergangsbereichs 11 sowie die keramischen Schichten 20, 2P des weiteren Übergangsbereichs 12 eine Reduzierung des d₃₃-Koeffizienten erzielt werden.

Durch eine oder eine Kombination dieser Maßnahmen kann somit eine gezielte Reduzierung des relevanten Materialparameters, nämlich des d₃₃-Koeffizienten, erreicht werden. Hierdurch kann die Dehnung in der gewünschten Weise beeinflusst werden, ohne dass eine Änderung der Schichtdicke 7 für die keramischen Schichten 2M bis 2P in den Übergangsbereichen 11, 12 erforderlich ist. Dies bedeutet, dass für die Reduzierung des Dehnungsvermögens in den keramischen Schichten 2M bis 2P in den Übergangsbereichen 11, 12 eine selektive Vergrößerung der Schichtdicken der keramischen Schichten 2M bis 2P nicht notwendigerweise erforderlich ist.

Die Reduzierung des d₃₃-Koeffizienten kann direkt durch Beeinflussung des intrinsischen Materialkoeffizienten, zum Beispiel durch eine veränderte Materialzusammensetzung, oder indirekt durch Reduzierung der Korngröße des piezokeramischen Materials erreicht werden. Die Veränderung der Korngröße kann wiederum entweder durch eine veränderte Materialzusammensetzung, vorzugsweise durch Zudotierung, oder durch eine veränderte Partikelgrößenverteilung des Vormaterials erzielt werden. Eine Reduzierung der Korngröße hat den zusätzlichen Vorteil, dass neben der Reduzierung der Materialbelastung, bei der die Dehnung und dadurch mechanische Spannungen verringert werden, zusätzlich die Belastbarkeit, insbesondere eine Festigkeit und Risszähigkeit, der Piezokeramik mit Abnehmen der Korngröße zunimmt.

Die Veränderung der Materialzusammensetzung mit dem Ziel einer intrinsischen Reduzierung des d₃₃-Koeffzienten und/oder einer reduzierten Korngröße durch geändertes Sinterverhalten kann entweder am Vormaterial vorgenommen werden oder in situ im Herstellungsprozess der Piezokeramik, insbesondere beim Sintern. Bei einer Veränderung der Zusammensetzung des Vormaterials kann ein anderes Material, das vergleichbare Verarbeitungseigenschaften und ein vergleichbares Sinterverhalten hat, für die keramischen Schichten 2M bis 2P der Übergangsbereiche 11, 12 eingesetzt werden. Möglich ist es auch, dass das bestehende Vormaterial durch Zudotierung, insbesondere durch Zudotierung am Kalzinat oder Gießschlicker, verändert wird.

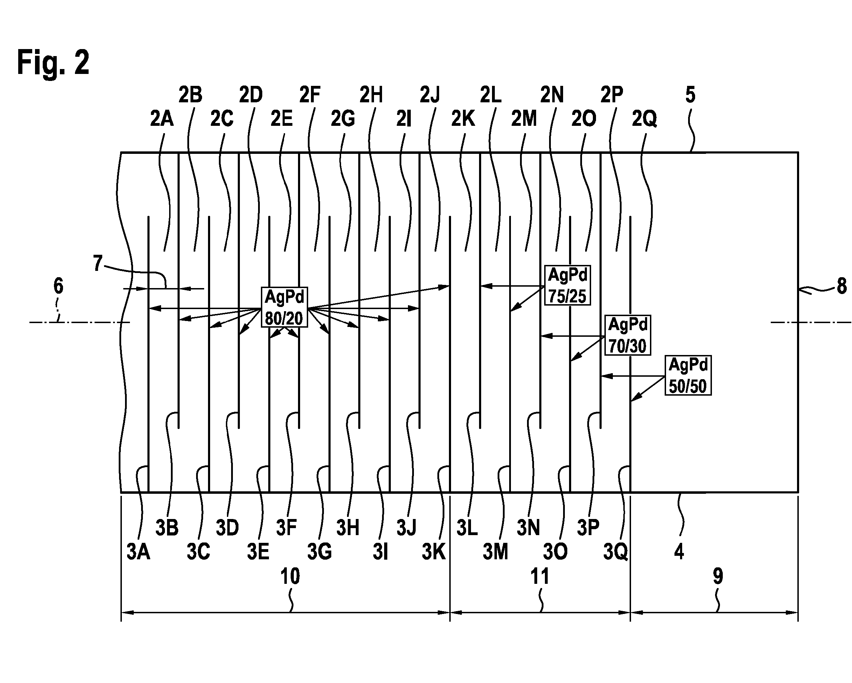

Die In-situ-Dotierung der Übergangsschichten im Herstellungsprozess des piezoelektrischen Aktors 1 kann beispielsweise durch zusätzliche Dotierungsschichten, beispielsweise im Siebdruck beim Grünaufbau, oder in vorteilhafter Weise zusammen mit dem Innenelektrodenmaterial aufgebracht werden. Besonders vorteilhaft ist hierbei eine Veränderung der Zusammensetzung des Materials der Innenelektroden 3M bis 3Q im Vergleich zu den Innenelektroden 3A bis 3L des aktiven Bereichs 10. Dies kann durch eine Dotierung der Innenelektrodenpaste für die Innenelektroden 3M bis 3Q mit entsprechend wirksamen Zusätzen erfolgen. Möglich ist auch eine Veränderung des Verhältnisses der Innenelektrodenbestandteile, wie es auch bei dem zweiten Ausführungsbeispiel anhand der Fig. 2 illustriert ist.

Fig. 2 zeigt den in Fig. 1 dargestellten piezoelektrischen Aktor 1 in einer auszugsweisen, schematischen Schnittdarstellung entsprechend einem zweiten Ausführungsbeispiel. Während bei dem anhand der Fig. 1 beschriebenen ersten Ausführungsbeispiel in dem aktiven Bereich 10, dem Übergangsbereich 11 und dem weiteren Übergangsbereich 12 jeweils ein keramisches Material mit in dem jeweiligen Bereich 10, 11, 12 zumindest näherungsweise konstanten d₃₃-Koeffzienten vorgegeben ist, wird bei dem zweiten Ausführungsbeispiel in dem Übergangsbereich 11 eine Variation des piezoelektrischen Koeffizienten des keramischen Materials für die keramischen Schichten 2K bis 2P des Übergangsbereichs 11 erreicht. Hierbei umfasst der Übergangsbereich 11 in dem zweiten Ausführungsbeispiel die keramischen Schichten 2K bis 2P, während der aktive Bereich 10 die keramischen Schichten 2A bis 2J umfasst.

Die Elektrodenschichten 3A bis 3K des aktiven Bereichs 9 weisen in diesem Ausführungsbeispiel die gleiche Zusammensetzung auf. Hierbei wird bei der Herstellung ein Innenelektrodenmaterial mit einem Molverhältnis von Silber zu Palladium von 80 zu 20 verwendet. Demgegenüber weisen die Elektrodenschichten 3L bis 3Q eine abweichende Zusammensetzung auf. Die Elektrodenschichten 3L, 3M des Übergangsbereichs 11 weisen einen reduzierten Silbergehalt und einen entsprechend erhöhten Palladiumgehalt auf, wobei ein Molverhältnis von Silber zu Palladium gleich 75 zu 25 ist. Der Silbergehalt der Elektrodenschichten 3N, 30 im Übergangsbereich 11 ist weiter reduziert, wobei sich ein Molverhältnis von Silber zu Palladium von 70 zu 30 ergibt. Die am nächsten an dem passiven Bereich 9 liegenden Elektrodenschichten 3P, 3Q des Übergangsbereichs 11 weisen einen weiter reduzierten Silbergehalt auf, wobei ein Molverhältnis von Silber zu Palladium gleich 50 zu 50 ist. Somit ändern sich die Verhältnisse der Innenelektrodenbestandteile der Elektrodenschichten 3L bis 3Q von dem aktiven Bereich 10 zu dem passiven Bereich 9 stufenweise.

Bei der Herstellung des piezoelektrischen Aktors 1 kann beispielsweise PZT-Keramik zur Ausgestaltung der keramischen Schichten 2A bis 2Q dienen. Solch ein keramisches Material kann eine signifikante Abhängigkeit der resultierenden elektromechanischen Eigenschaften vom Silbergehalt der angrenzenden Elektrodenschichten 3A bis 3Q zeigen. Durch einen reduzierten Silbergehalt, beispielsweise unter Anhebung des Palladiumgehalts, wird bei unveränderten Sinterbedingungen eine signifikant reduzierte Korngröße in dem piezokeramischen Material mit entsprechend geringerer Dehnung und erhöhter Festigkeit erzielt. Dies kann für die Herstellung eines stufenartigen Dehnungsübergangs im Übergangsbereich 11 genutzt werden, indem das Verhältnis von Silber zu Palladium der Innenelektroden schrittweise abgesenkt wird. Hierdurch wird ein stufenartiger Übergang der Korngröße und somit auch des d₃₃-Koeffizienten und damit ferner der mechanischen Dehnung bei gleich bleibender Schichtdicke 7 erzeugt. Zusätzlich kann in dem keramischen Material, das von Elektrodenschichten unterschiedlicher Zusammensetzung eingefasst ist, beispielsweise einem Verhältnis von Silber zu Palladium von 75 zu 25 auf der einen und von 70 zu 20 auf der anderen Seite der keramischen Schicht, je nach Schichtdicke und Diffusionsverhalten beim Sinterprozess ein kontinuierlicher gradueller Übergang innerhalb der einzelnen piezokeramischen Schichten erzeugt werden, was eine weitergehende Robustheitssteigerung zur Folge hat. Beispielsweise ist die keramische Schicht 2M auf der einen Seite von der Elektrodenschicht mit einem Verhältnis von Silber zu Palladium von 75 zu 25 begrenzt und auf der anderen Seite von der Elektrodenschicht 3N mit einer Zusammensetzung von 70 zu 30 begrenzt.

Somit kann durch eine sukzessive Änderung des Ag/Pd-Verhältnisses in den Innenelektroden 3A bis 3Q eine veränderte Dotierung/Zusammensetzung der keramischen Schichten 2K bis 2P im Übergangsbereich 11 erzielt werden. Durch den in Richtung zu dem passiven Bereich 9 hin schrittweise reduzierten Silbergehalt in den Elektrodenschichten 3L bis 3Q wird eine entsprechende schrittweise beziehungsweise graduelle Reduzierung der Menge des in die Piezokeramik eindiffundierenden Silbers bewirkt. Dementsprechend wird das Sinterverhalten in den jeweiligen piezokeramischen Schichten 2K bis 2P derart verändert, dass sich in Richtung des passiven Bereichs 9 eine zunehmend kleinere Korngröße der Piezokeramik einstellt, was bei unveränderter Schichtdicke zu den Vorteilen einer reduzierten Dehnung, einer erhöhten Festigkeit und einer dadurch erhöhten Robustheit im Vergleich zu einem Aktor ohne Dehnungsübergang beziehungsweise zu einem erhöhten Arbeitsvermögen gegenüber einem Aktor mit Schichtdickenübergang führt.

Der piezoelektrische Aktor 1 kann beispielsweise für Einspritzsysteme für Brennkraftmaschinen oder auch für andere elektrische oder elektronische, keramische Schichtbauelemente zum Einsatz kommen.

Die Erfindung ist nicht auf die beschriebenen Ausführungsbeispiele beschränkt.

## Patentansprüche

1. Piezoelektrischer Aktor (1) mit einer Vielzahl von keramischen Schichten (2A - 2Q) und einer Vielzahl von zwischen den keramischen Schichten (2A - 2Q) angeordneten Elektrodenschichten (3A - 3Q), wobei ein aktiver Bereich (10) und zumindest ein Übergangsbereich (11) vorgesehen sind, und wobei ein piezoelektrischer Koeffizient eines keramischen Materials zumindest einer keramischen Schicht (2M - 2P) im Übergangsbereich (11) kleiner ist als der piezoelektrische Koeffizient eines keramischen Materials der keramischen Schichten (2A - 2J) im aktiven Bereich (10),
**dadurch gekennzeichnet, dass**
der piezoelektrische Koeffizient ein d₃₃-Koeffizient ist und das keramische Material der keramischen Schichten (2M - 2P) im Übergangsbereich (11) und das keramische Material der keramischen Schichten (2A - 2J) im aktiven Bereich (10) eine unterschiedliche Zusammensetzung aufweisen, wobei die unterschiedliche Zusammensetzung des keramischen Materials der keramischen Schichten (2M - 2P) im Übergangsbereich (11) und/oder des keramischen Materials der keramischen Schichten (2A - 2J) im aktiven Bereich (10) durch an das keramische Material angrenzende und/oder in das keramische Material eingebrachte Dotierungsschichten vorgegeben ist, wobei alle keramischen Schichten (2A-2P) die gleiche Dicke (7) aufweisen.

2. Piezoelektrischer Aktor nach Anspruch 1,
**dadurch gekennzeichnet,**
**dass** der piezoelektrische Koeffizient des keramischen Materials der keramischen Schichten (2M - 2P) im Übergangsbereich (11) zumindest näherungsweise konstant ist und/oder dass der piezoelektrische Koeffizient des keramischen Materials der keramischen Schichten (2A - 2J) im aktiven Bereich (10) zumindest näherungsweise konstant ist.

3. Piezoelektrischer Aktor nach Anspruch 1,
**dadurch gekennzeichnet,**
**dass** die unterschiedliche Zusammensetzung des keramischen Materials der keramischen Schichten (2M - 2P) im Übergangsbereich (11) und des keramischen Materials der keramischen Schichten (2A - 2J) im aktiven Bereich (10) durch einen unterschiedlichen Versatz und/oder eine Zudotierung und/oder eine unterschiedliche Zudotierung und/oder eine In-situ-Dotierung beim Sinterprozess und/oder eine unterschiedliche In-situ-Dotierung beim Sinterprozess vorgegeben ist.

4. Piezoelektrischer Aktor nach Anspruch 1 oder 3,
**dadurch gekennzeichnet,**
**dass** die unterschiedliche Zusammensetzung des keramischen Materials der keramischen Schichten (2M - 2P) im Übergangsbereich (11) und/oder des keramischen Materials der keramischen Schichten (2A - 2J) im aktiven Bereich (10) durch eine unterschiedliche Zusammensetzung der zwischen den keramischen Schichten (2K - 2P) angeordneten Elektrodenschichten (3L - 3Q) vorgegeben ist.

5. Piezoelektrischer Aktor nach Anspruch 4,
**dadurch gekennzeichnet,**
**dass** ein Material der Elektrodenschichten (3L - 3Q) im Übergangsbereich (11) einen veränderten Anteil an Silber in Bezug auf ein Material der Elektrodenschichten (3A - 3K) im aktiven Bereich (10) aufweist und/oder
**dass** die unterschiedliche Zusammensetzung der Elektrodenschichten (3A - 3Q) durch zumindest einen Dotierungszusatz und/oder durch unterschiedliche Dotierungszusätze vorgegeben ist.

6. Piezoelektrischer Aktor nach einem der Ansprüche 1 bis 5,
**dadurch gekennzeichnet,**
**dass** das keramische Material der keramischen Schichten (2M - 2P) im Übergangsbereich (11) eine kleinere Korngröße aufweist als das keramische Material der keramischen Schichten im aktiven Bereich (10).

7. Piezoelektrischer Aktor nach einem der Ansprüche 1 bis 6,
**dadurch gekennzeichnet,**
**dass** zumindest ein passiver Bereich (9) vorgesehen ist und dass die keramischen Schichten (2M - 2P) des Übergangsbereichs (11) zwischen dem aktiven Bereich (10) und dem passiven Bereich (9) angeordnet sind.

8. Piezoelektrischer Aktor nach einem der Ansprüche 1 bis 7,
**dadurch gekennzeichnet,**
**dass** zumindest ein weiterer Übergangsbereich (12) vorgesehen ist, dass der Übergangsbereich (11) zwischen dem aktiven Bereich (10) und dem weiteren Übergangsbereich (12) angeordnet ist und dass der piezoelektrische Koeffizient eines keramischen Materials der keramischen Schichten (20, 2P) im weiteren Übergangsbereich (12) kleiner ist als der piezoelektrische Koeffizient des keramischen Materials der keramischen Schichten (2M, 2N) im Übergangsbereich (11).

## Claims

1. Piezoelectric actuator (1) having a multiplicity of ceramic layers (2A - 2Q) and a multiplicity of electrode layers (3A - 3Q) arranged between the ceramic layers (2A - 2Q), wherein an active region (10) and at least one transition region (11) are provided, and wherein a piezoelectric coefficient of a ceramic material of at least one ceramic layer (2M - 2P) in the transition region (11) is lower than the piezoelectric coefficient of a ceramic material of the ceramic layers (2A - 2J) in the active region (10),
**characterized in that**
the piezoelectric coefficient is a d₃₃ coefficient, and the ceramic material of the ceramic layers (2M - 2P) in the transition region (11) and the ceramic material of the ceramic layers (2A - 2J) in the active region (10) have a different composition, wherein the different composition of the ceramic material of the ceramic layers (2M - 2P) in the transition region (11) and/or of the ceramic material of the ceramic layers (2A - 2J) in the active region (10) is prescribed by doping layers which adjoin the ceramic material and/or are introduced into the ceramic material, wherein all of the ceramic layers (2A - 2P) have the same thickness (7).

2. Piezoelectric actuator according to Claim 1,
**characterized**
**in that** the piezoelectric coefficient of the ceramic material of the ceramic layers (2M - 2P) in the transition region (11) is at least approximately constant and/or in that the piezoelectric coefficient of the ceramic material of the ceramic layers (2A - 2J) in the active region (10) is at least approximately constant.

3. Piezoelectric actuator according to Claim 1,
**characterized**
**in that** the different composition of the ceramic material of the ceramic layers (2M - 2P) in the transition region (11) and of the ceramic material of the ceramic layers (2A - 2J) in the active region (10) is prescribed by a different offset and/or added doping and/or different added doping and/or in-situ doping during the sintering process and/or different in-situ doping during the sintering process.

4. Piezoelectric actuator according to Claim 1 or 3,
**characterized**
**in that** the different composition of the ceramic material of the ceramic layers (2M - 2P) in the transition region (11) and/or of the ceramic material of the ceramic layers (2A - 2J) in the active region (10) is prescribed by a different composition of the electrode layers (3L - 3Q) arranged between the ceramic layers (2K - 2P).

5. Piezoelectric actuator according to Claim 4,
**characterized**
**in that** a material of the electrode layers (3L - 3Q) in the transition region (11) has a modified proportion of silver in relation to a material of the electrode layers (3A - 3K) in the active region (10)
and/or
**in that** the different composition of the electrode layers (3A - 3Q) is prescribed by at least one doping additive and/or by different doping additives.

6. Piezoelectric actuator according to one of Claims 1 to 5,
**characterized**
**in that** the ceramic material of the ceramic layers (2M - 2P) in the transition region (11) has a smaller grain size than the ceramic material of the ceramic layers in the active region (10).

7. Piezoelectric actuator according to one of Claims 1 to 6,
**characterized**
**in that** at least one passive region (9) is provided and in that the ceramic layers (2M - 2P) of the transition region (11) are arranged between the active region (10) and the passive region (9).

8. Piezoelectric actuator according to one of Claims 1 to 7,
**characterized**
**in that** at least one further transition region (12) is provided, in that the transition region (11) is arranged between the active region (10) and the further transition region (12) and in that the piezoelectric coefficient of a ceramic material of the ceramic layers (20, 2P) in the further transition region (12) is lower than the piezoelectric coefficient of the ceramic material of the ceramic layers (2M, 2N) in the transition region (11).

## Revendications

1. Actionneur piézoélectrique (1) doté de plusieurs couches céramiques (2A - 2Q) et de plusieurs couches d'électrode (3A - 3Q) disposées entre les couches céramiques (2A - 2Q),
une partie active (10) et au moins une partie de transition (11) étant prévue,
un coefficient piézoélectrique d'un matériau céramique d'au moins une couche céramique (2M - 2P) de la partie de transition (11) étant plus petit que le coefficient piézoélectrique d'un matériau céramique des couches céramiques (2A - 2J) de la partie active (10), **caractérisé en ce que**
le coefficient piézoélectrique est un coefficient d₃₃ et le matériau céramique des couches céramiques (2M - 2P) de la partie de transition (11) et le matériau céramique des couches céramiques (2A - 2J) de la partie active (10) présentent des compositions différentes,
**en ce que** les compositions différentes du matériau céramique des couches céramiques (2M - 2P) de la partie de transition (11) et/ou du matériau céramique des couches céramiques (2A - 2J) de la partie active (10) sont prédéterminées par des couches de dopage adjacentes au matériau céramique et/ou formées dans le matériau céramique et
**en ce que** toutes les couches céramiques (2A - 2P) présentent la même épaisseur (7).

2. Actionneur piézoélectrique selon la revendication 1, **caractérisé en ce que** le coefficient piézoélectrique du matériau céramique des couches céramiques (2M - 2P) de la partie de transition (11) est au moins approximativement constant et/ou **en ce que** le coefficient piézoélectrique du matériau céramique des couches céramiques (2A - 2J) de la partie active (10) est au moins approximativement constant.

3. Actionneur piézoélectrique selon la revendication 1, **caractérisé en ce que** les compositions différentes du matériau céramique des couches céramiques (2M - 2P) de la partie de transition (11) et du matériau céramique des couches céramiques (2A - 2J) de la partie active (10) sont prédéterminées par un décalage différent, un dopage, un dopage différent, un dopage "in situ" lors d'une opération de frittage et/ou un dopage "in situ" différent lors de l'opération de frittage.

4. Actionneur piézoélectrique selon les revendications 1 ou 3, **caractérisé en ce que** les compositions différentes du matériau céramique des couches céramiques (2M - 2P) de la partie de transition (11) et/ou du matériau céramique des couches céramiques (2A - 2J) de la partie active (10) sont prédéterminées par des compositions différentes des couches d'électrode (3L - 3Q) disposées entre les couches céramiques (2K - 2P).

5. Actionneur piézoélectrique selon la revendication 4, **caractérisé en ce qu'**un matériau des couches d'électrode (3L - 3Q) de la partie de transition (11) présente une teneur en argent différente de celle du matériau des couches d'électrode (3A - 3K) de la partie active (10) et/ou **en ce que** les compositions différentes des couches d'électrode (3A - 3Q) sont prédéterminées par au moins une addition de dopage et/ou par des additions de dopage différentes.

6. Actionneur piézoélectrique selon l'une des revendications 1 à 5, **caractérisé en ce que** le matériau céramique des couches céramiques (2M - 2P) de la partie de transition (11) présente des grains de taille plus petite que le matériau céramique des couches céramiques de la partie active (10).

7. Actionneur piézoélectrique selon l'une des revendications 1 à 6, **caractérisé en ce qu'**au moins une partie passive (9) est prévue et **en ce que** les couches céramiques (2M - 2P) de la partie de transition (11) sont disposées entre la partie active (10) et la partie passive (9).

8. Actionneur piézoélectrique selon l'une des revendications 1 à 7, **caractérisé en ce qu'**au moins une autre partie de transition (12) est prévue, **en ce que** la partie de transition (11) est disposée entre la partie active (10) et l'autre partie de transition (12) et **en ce que** le coefficient piézoélectrique d'un matériau céramique des couches céramiques (20 - 2P) de l'autre partie de transition (12) est plus petit que le coefficient piézoélectrique du matériau céramique des couches céramiques (2M - 2N) de la partie de transition (11).
